# EUROPÄISCHE PATENTSCHRIFT

(11) **EP 0 486 873 B1**
(45) Veröffentlichungstag und Bekanntmachung des Hinweises auf die Patenterteilung: **14.05.1997**
(21) Anmeldenummer: 91118871.2
(22) Anmeldetag: 06.11.1991
(51) Int. Cl.: H01L 21/306, C25F 3/12

(54) **Elektrochemisches Verfahren zum anisotropen Ätzen von Silizium**
Electrochemical method for anisotropic etching of silicon
Méthode électrochimique pour gravure anisotropique de silicium

(30) Priorität: 20.11.1990 DE 4036895
(43) Veröffentlichungstag der Anmeldung: 27.05.1992
(73) Patentinhaber: DAIMLER-BENZ AKTIENGESELLSCHAFT, 70546 Stuttgart (DE)
(72) Erfinder: Voss, Ralf, W-8130 Starnberg (DE); Seidl, Helmut, Dr., W-8130 Starnberg (DE)

(56) Entgegenhaltungen:
- EP-A- 0 037 876
- FR-A- 2 070 873
- US-A- 4 369 099
- US-A- 4 482 443
- IEEE TRANSACTIONS ON ELECTRON DEVICES Bd. 36, Nr. 4, April 1989, NEW YORK US Seiten 663 - 669; BEN KLOECK ET AL.: 'Study of electrochemical etch-stop for high-precision thickness control of Silicon membranes'
- JOURNAL OF VACUUM SCIENCE AND TECHNOLOGY: PART B. Bd. 1, Nr. 1, Januar 1983, NEW YORK US Seiten 48 - 53; S. MENEZES ET AL.: 'Electrodissolution and passivation phenomena in III-V semiconducting compounds'
- JOURNAL OF THE ELECTROCHEMICAL SOCIETY. Bd. 131, Nr. 1, Januar 1984, MANCHESTER, NEW HAMPSHIRE US Seiten 27 - 34; EDOUARD HAROUTIOUNIAN ET AL.: 'Electrochemical and photoelectrochemical behavior and selective etching of III-V semiconductors in H2O2 as redox system'
- PATENT ABSTRACTS OF JAPAN vol. 9, no. 31 (E-295)9. Februar 1985 & JP-A-59 175 127 ( DAINIPPON INSATSU K.K. ) 3. Oktober 1984
- J. Electrochemical Society. 132(1), S. 145-151, 1985

## Beschreibung

Die Erfindung bezieht sich auf ein elektrochemisches Verfahren zum anisotropen Ätzen von Silizium gemäß dem Oberbegriff des Anspruchs 1 und des Anspruchs 2.

Zur Herstellung von dreidimensionalen Mikrostrukturen und Mikrobauelementen aus einkristallinem Silizium ist das naßchemische anisotrope Siliziumätzen eine bekannte und vorwiegend verwendete Technologie. Diese Bedeutung resultiert aus der Möglichkeit, den Ätzprozeß gezielt zu steuern durch die Abhängigkeit der Ätzgeschwindigkeit von der Kristallrichtung, von der Dotierung und von einer externen, an das Halbleitersubstrat angelegten Spannung. Dieses Verfahren ist unter der Bezeichnung "elektrochemisches anisotropes Ätzen" bekannt. Der entscheidende Effekt der Anisotropie besteht in der um ca. zwei Größenordnungen geringeren Ätzrate der (111)-Kristallebenen im Vergleich zu allen anderen Kristallebenen.

Die bisher bekannte Potentialabhängkeit des Siliziumätzens wird im Hinblick auf eine monolithische Integration in der Mikromechanik genutzt. Der dabei auftretende Effekt der Ätzratenreduktion um zwei bis drei Größenordnungen durch Anlegen einer positiven Vorspannung wird bei einem in Sperrrichtung geschalteten p/n-Übergang zur Erzeugung von dünnen Membranen oder Zungenstrukturen verwendet. Die Dicke der Struktur wird durch eine entsprechend tiefe "n-Schicht", die diffundiert oder epitaktisch abgeschieden werden kann, definiert. Der Ätzprozeß kommt durch die Potentialdifferenz an der Grenzschicht des p/n-Überganges zum Erliegen. Im Prinzip besitzt jede basische Lösung mit einem pH-Wert größer als 12 diese Eigenschaften. Typische Ätzlösungen, die weitverbreitete Anwendungen gefunden haben, sind KOH, NaOH, CsOH, NH₄OH usw. sowie organische Lösungen mit Ethylendiamin oder Hydrazin.

Ein photoelektochemisches Verfahren zum Ätzen von n-Typ-Silizium ist in der US-A-4 482 443 beschrieben, dabei wird eine saure Lösung auf der Basis von Flußsäure und Alkohol als Elektrolyt benutzt. In einem elektro-chemischen Aufbau wird der Ätzvorgang durch die Bestrahlung mit Licht überhaupt erst ausgelöst.

Aus der Druckschrift "Journal of the Electrochemical Society"- Bd. 135, Nr. 1, Jan. 85, Seiten 145 - 151, ist es bekannt, alkalische Lösungen insbesondere Kalilauge als Elektrolyten für das elektrochemische Ätzen von Silizium zu verwenden. Die Maßnahmen zur Lösung der gestellten Aufgabe sind jedoch nicht erkannt worden.

Mit Hilfe der vorgenannten Verfahren wird eine Vielzahl mikromechanischer Bauelemente, wie z.B. Sensoren für Druck, Beschleunigung und Durchfluß oder Mikroventile, Mikropumpen und Stecker für Lichtleitfasern hergestellt. Trotz der großen Freiheitsgrade, die diese zum Stand der Technik zählenden Verfahren bei der Herstellung von Bauelementen bieten, sind jedoch nicht zu übersehende Beschränkungen gegeben. Insbesondere die kristalline Struktur des Siliziums, von der Natur her vorgegeben, kann nicht verändert werden, so daß die Anisotropie des Ätzprozesses immer genau auf die kristallographischen Gegebenheiten des Substrates ausgelegt werden muß.

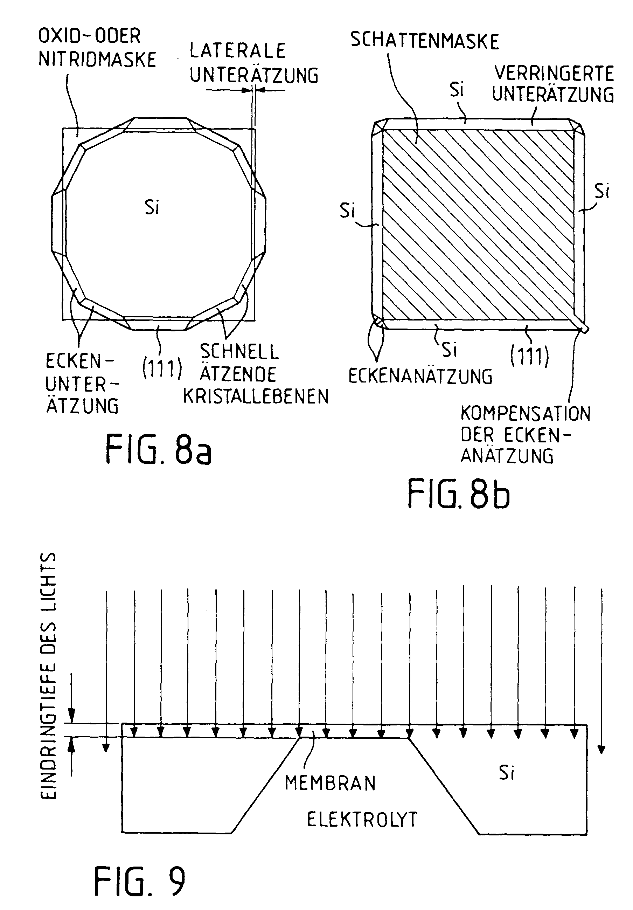

Weiterhin treten an konvexen Strukturen - wie z. B. der seismischen Masse eines Beschleunigungssensors - unerwünschte Unterätzungseffekte an den Ecken auf (Fig. 8a), die bisher nur mühsam und relativ ungenügend kompensiert werden können.

Der Erfindung liegt die Aufgabe zugrunde, ein Verfahren aufzuzeigen mit dem vorgenannte Nachteile beseitigt werden können und insbesondere neue Freiheitsgrade im Sinne einer Anisotropie zwischen der schnellen vertikalen und der langsamen lateralen Ätzrichtung weitgehend unabhängig von der Kristallografie erzielt werden können.

Diese Aufgabe wird durch die im Anspruch 1 und Anspruch 2 aufgezeigten Maßnahmen gelöst. In den Unteransprüchen sind Ausgestaltungen und Weiterbildungen des Verfahrens angegeben. In der nachfolgenden Beschreibung werden Ausführungsbeispiele erläutert und diese Erläuterungen durch die Figuren der Zeichnung ergänzt. Es zeigen:
- Fig. 1: ein Schemabild einer Einrichtung zur Durchführung des vorgeschlagenen lichtinduzierten bzw. lichtpassvierten elektrochemischen Ätzens,
- Flg. 2: ein Voltamogramm für p-dotiertes unbeleuchtetes und eines für beleuchtetes Silizium in einer Ätzlösung KOH, 30 %, 60° C,
- Fig. 3: ein Voltamogramm für n-dotiertes unbeleuchtetes und eines für beleuchtetes Silizium in einer Ätzlösung KOH, 30 %, 60° C,
- Fig. 4: eine perspektivische Ansicht ausgeätzter quaderförmiger Säulen auf einer (100)-Oberfläche des Siliziumkristalls,
- Fig. 5: eine perspektivische Ansicht eines Silizium-Bauelementes mit Kühlkanälen auf einer (100)-Oberfläche,
- Fig. 6: eine perspektivische Ansicht der bisherigen Methode zur Erzeugung von senkrechten (111)-Kristallebenen auf (110)-Siliziumsubstrat,
- Fig. 7: eine perspektivische Ansicht zur Erzeugung von senkrechten (lll)-Silizium-Kristallebenen auf (110)-Oberfläche mittels lichtinduziertem Ätzen,
- Fig. 8a: eine Draufsicht der Eckenunterätzungen gemäß den Verfahren nach dem Stand der Technik in schematischer Darstellung,
- Fig. 8b: eine Draufsicht der Eckenunterätzungen am mit einer Schattenmaske abgedeckten Siliziumsubstrat beim lichtinduzierten Ätzen,
- Fig. 9: ein Schemabild zur Erzeugung einer Membran mit lichtpassiviertem Ätzen, wobei die Dicke der Membran von der Eindringtiefe des Lichtes abhängt.

Intensive Uberlegungen und Versuche zur Spannungsabhängigkeit des Ätzens führten zu dem Ergebnis, daß bei p-dotierten Siliziumproben, welche sich auf einem Passivierungspotential befinden, durch eine Bestrahlung mit Licht, ein Wiederbeginn des Ätzens hervorgerufen wird. Hierbei liegen die lichtinduzierten Ätzraten in der Größenordnung des spannungslosen Ätzens. Durch selektive Bestrahlung des Substrates mit Hilfe einer Maske oder mit Hilfe eines fokussierten Laserstrahles kann der Ätzprozeß auch örtlich selektiv ausgelöst werden. An beleuchteten Stellen wird das Ätzen induziert, dagegen in abgeschatteten Regionen bleibt das Material passiviert.

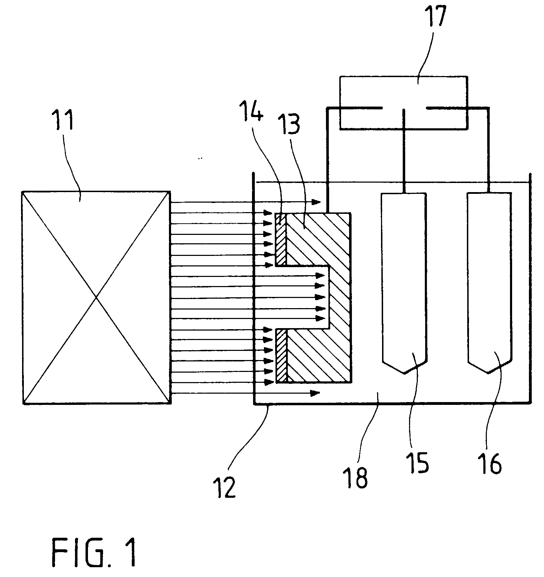

In Fig. 1 ist ein prinzipieller elektrochemischer Aufbau einer Ätzapparatur skizziert. Diese besteht aus einem Ätzgefäß 12, in dem sich eine Referenzelektrode 15 - beispielsweise aus Hg/HgO - , eine Gegenelektrode 16 - beispielsweise aus Pt - , eine Siliziumprobe 13 als Arbeitselektrode und der Elektrolyt 18 - beispielsweise KOH - befinden. Die genannten Elektroden 13, 15, 16 werden über einen Potentiostaten 17 angesteuert. Als Lichtquelle 11 dient ein optischer Aufbau, der für eine weitgehend gleichmäßige, parallele Bestrahlung des Siliziumsubstrats sorgt. Die Selektivität der Beleuchtung wird durch eine Schattenmaske 14 erzeugt, die sich unmittelbar auf der Siliziumscheibe befindet, beispielsweise in Form einer metallischen Dünnfilmbeschichtung.

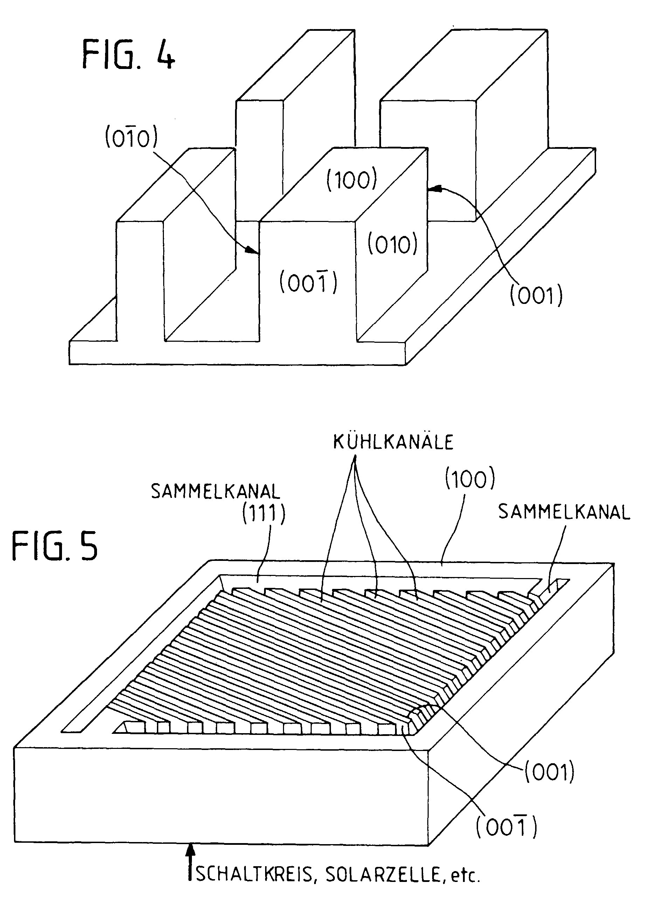

Alternativ kann als Strahlungsquelle auch ein fokussierbarer Laserstrahl eingesetzt werden, der rechnergesteuert die Scheibe mit dem gewünschten Muster abrastert (Fig. 4 bis 7). Für die Strahlungsquelle gilt die Forderung, daß sie entsprechend der Bandlücke des Siliziums eine Lichtwellenlänge kleiner als 1,1 µm besitzt. Somit ist also normales sichtbares Licht verwendbar.

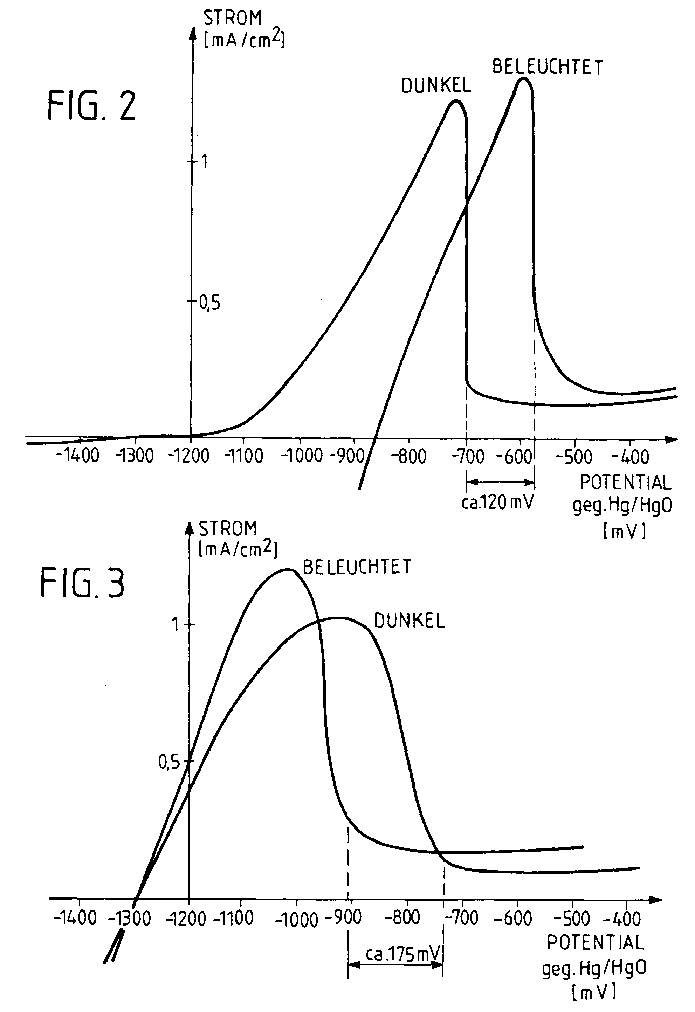

Die Fig. 2 zeigt die Darstellung zweier Voltamogramme bei p-dotiertem Silizium mit und ohne Lichteinwirkung, bei denen die Verschiebung des Ätzstoppotentials deutlich zu erkennen ist. Die Weite der Verschiebung hängt von der Intensität des eingestrahlten Lichtes ab. Um den Effekt richtig auszunutzen, muß die angelegte Spannung genau zwischen den beiden Stoppotentialen gewählt werden.

Der umgekehrte Effekt liegt bei n-dotiertem Silizium vor. Dort wird bei geeigneter Wahl der Vorspannung der bereits laufende Ätzvorgang durch eine Einstrahlung von Licht gestoppt. Das dazugehörige Paar von Voltamogrammen ist in Fig. 3 dargestellt. Auch hier ist eine Verschiebung des Ätzstoppotentials durch die Einwirkung von Licht gegeben, allerdings diesmal in entgegengesetzter Richtung, verglichen mit p-Silizium.

Durch dieses lichtgesteuerte selektive Ätzen ist vor allem im Bereich der Mikromechanik wie auch in der Mikroelektronik eine Vielfältigkeit zur Herstellung von Mikrostrukturen und Bauelementen geschaffen worden, für die nachstehende Ausführungsbeispiele zeugen sollen.

Auf Siliziumscheiben der Kristallorientierung (100) lassen sich mit Hilfe von hochprozentigen KOH-Lösungen Strukturen mit vertikalen (100)-Ebenen als Seitenbegrenzungen bzw. -wandungen erzeugen. Ohne Einsatz des erfindungsgemäßen Verfahrens ist der laterale Unterätzeffekt jedoch gleichgroß wie der vertikale, so daß keine hohen Aspektverhältnisse in reproduzierbarer Weise erzielbar sind. Mit Hilfe des hier vorgeschlagenen lichtinduzierten Ätzverfahrens kann die vertikale Ätzrate gegenüber der lateralen jedoch wesentlich erhöht werden. Nunmehr können quaderförmige Säulenstrukturen - wie sie beispielsweise die Fig. 4 veranschaulicht - mit gut definierten, vertikalen Seitenwänden erzeugt werden.

Eine analoge Anwendung veranschaulicht die Fig. 5. Hier werden nach dem vorgeschlagenen Verfahren erzeugte Kühlkanäle für Laserspiegel, Solarzellen oder ähnlich fein zu strukturierende Bauelemente gezeigt. Darüberhinaus ist die Erzeugung von ca. 1 µm schmalen Trenchgräben zur Anordnung von Isolationsgräben für Hochleistungsbauelemente möglich. Diese werden bisher mit üblichen bekannten Trockenätzverfahren hergestellt, wobei es sehr schwierig ist, Gräben mit hohen Aspektverhältnissen und guter Flankensteilheit zu erzielen.

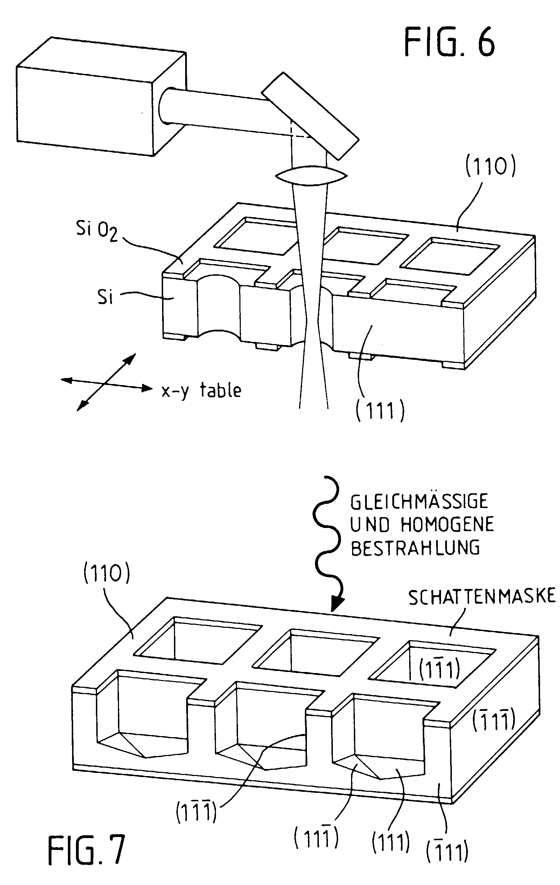

Ein weiteres Beispiel ist die Erzeugung von vertikalen Schächten in Siliziumscheiben der Orientierung (110). Beim Stand der Technik ist dies nur möglich, wenn zuerst ein Loch mit einem Laserstrahl vorgebohrt wird, wobei das Material verdampft (Fig. 6). Durch das hier vorgeschlagene Verfahren kann nunmehr das anisotrope Durchätzen mit Hilfe einer großflächigen Bestrahlung und einer entsprechenden Schattenmaske problemlos und exakt durchgeführt werden (Fig. 7).

Bei der Erzeugung von mikromechanischen Mesastrukturen tritt generell das Problem der Unterätzung an konvexen Ecken auf, wie die Fig. 8a veranschaulicht. Dies ist beispielsweise beim Strukturieren der seismischen Masse eines mikromechanischen Beschleunigungssensors der Fall. Auch hier bringt eine intransparente Schattenmaske - beispielsweise ein metallischer Dünnfilm - und die Beleuchtung bei gleichzeitigem Dunkel-Passivierungspotential eine ganz wesentlich Verbesserung (Fig. 8b).

Es darf festgestellt werden, daß nunmehr der Ätzvorgang weitgehend unabhängig von der Kristallographie ist und eine Anisotropie zwischen schnelleren vertikalen und langsameren lateralen Ätzrichtungen erzielt wird. Das bedeutet, daß sich eine planare Schattenmaske mit sehr geringer seitlicher Unterätzung, natürlich bei geeigneter Justierung, in die Tiefe "abbilden" läßt. Dabei erscheinen Tiefen von der Dicke des Siliziumsubstrates erreichbar.

Neue Möglichkeiten sind auch durch den vorbeschriebenen zweiten Effekt des Verfahrens gegeben. Es kann beispielsweise die Dicke einer Membran durch die Eindringtiefe des Lichts in das Material gesteuert werden, wie die Fig. 9 veranschaulicht. Die bisher aufwendige und teuere Epitaxie zur Membranerzeugung entfällt nunmehr.

Die vorgenannten Beispiele zeigen die Vielfältigkeit der Anwendungsmöglichkeiten, die jedoch damit bei weitem noch nicht ausgeschöpft sind. So ist beispielsweise auch die Erzeugung von Trenchgräben bei der Kondensatorherstellung in der Höchstintegration möglich, deren Form nunmehr mit kantigem Querschnitt herstellbar ist.

## Patentansprüche

1. Elektrochemisches Verfahren zum anisotropen Ätzen von ganz oder zumindest teilweise p-dotiertem Silizium unter Verwendung einer basischen Lösung bei einem pH-Wert grösser als 12, wobei durch das Anlegen einer positiven Spannung relativ zum Ruhepotential an die p-dotierten Bereiche des Siliziums eine Ätzratenreduktion um zwei bis drei Grössenordnungen erzielt wird und wobei sich in unbeleuchtetem Zustand auf einem einen Ätzstopp hervorrufenden Potential befindliches p-dotiertes Silizium mit Licht der Wellenlänge kleiner als 1.1 micrometer bestrahlt wird und damit das Ätzstopp-Potential derart in anodische Richtung verschoben wird, dass der Ätzvorgang ausgelöst wird, wobei die angelegte Spannung so gewählt wird, dass sie zwischen den Ätzstopp-Potentialen mit und ohne Beleuchtung liegt.

2. Elektrochemisches Verfahren zum anisotropen Ätzen von ganz oder zumindest teilweise n-dotiertem Silizium unter Verwendung einer basischen Lösung bei einem pH-Wert grösser als 12, wobei durch das Anlegen einer positiven Spannung relativ zum Ruhepotential an die n-dotierten Bereiche des Siliziums eine Ätzratenreduktion um zwei bis drei Grössenordnungen erzielt wird und wobei sich in unbeleuchtetem Zustand auf positiver Vorspannung aber gerade noch unterhalb des Dunkel-Ätzstopp-Potentials befindliches n-dotiertes Silizium mit Licht der Wellenlänge kleiner als 1.1 micrometer bestrahlt wird und damit das Ätzstopp-Potential derart in kathodische Richtung verschoben wird, dass der laufende Ätzvorgang gestoppt wird.

3. Verfahren nach Anspruch 1 oder 2, **dadurch gekennzeichnet**, daß das Silizium mit Hilfe eines fokussierten Laserstrahls selektiv bestrahlt wird.

4. Verfahren nach Anspruch 1 oder 2, **dadurch gekennzeichnet**, daß eine selektive Bestrahlung des Siliziums mit Hilfe einer der gewünschten Strukturform entsprechenden Maske durchgeführt wird.

5. Verfahren nach einem oder mehreren den Ansprüchen 1 bis 4, **dadurch gekennzeichnet**, daß die Eindringtiefe des Lichts in das Silizium zur Dickesteuerung von Membranen, Brücken oder Stegen eingesetzt wird.

6. Verfahren nach einem oder mehreren der Ansprüche 1 bis 5, **dadurch gekennzeichnet**, daß als basische Lösung KOH, NaOH, NH₄OH oder CsOH verwendet wird.

## Claims

1. Electrochemical process for anisotropic etching of wholly or at least partly p-doped silicon using a basic solution having a pH value greater than 12, wherein by the application to the p-doped regions of the silicon of a voltage that is positive with respect to the rest potential a reduction in etch rate of two to three orders of magnitude is achieved and wherein p-doped silicon - which is at a potential that in the unilluminated state causes etch stop - is irradiated with light of a wavelength smaller than 1.1 micrometer, thereby displacing the etch stop potential in the anodic direction such that the etching process is triggered, wherein the applied voltage is so chosen that it lies between the etch stop potentials with and without illumination.

2. Electrochemical process for anisotropic etching of wholly or at least partly n-doped silicon using a basic solution having a pH value greater than 12, wherein by the application to the n-doped regions of the silicon of a voltage that is positive with respect to the rest potential a reduction in etch rate of two to three orders of magnitude is achieved, and wherein n-doped silicon - which is in the unilluminated state at a positive bias voltage but just below the dark etch stop potential - is irradiated with light of a wavelength smaller than 1.1 micrometer, thereby displacing the etch stop potential in the cathodic direction such that the ongoing etching process is stopped.

3. Process according to claim 1 or 2, characterised in that the silicon is selectively irradiated by means of a focussed laser beam.

4. Process according to claim 1 or 2, characterised in that selective irradiation of the silicon is carried out by means of a mask corresponding to the desired structural form.

5. Process according to one or more of claims 1 to 4, characterised in that the penetration depth of the light into the silicon is employed to control the thickness of membranes, bridges or webs.

6. Process according to one or more of claims 1 to 5, characterised in that KOH, NaOH, NH₄OH or CsOH is used for the basic solution.

## Revendications

1. Procédé électrochimique pour la gravure anisotrope de silicium à dopage p intégral ou au moins partiel, à l'aide d'une solution basique avec un pH supérieur à 12, une réduction d'ordre deux à trois de la vitesse de gravure étant obtenue par l'application aux zones du silicium à dopage p d'une tension positive par rapport au potentiel de repos et du silicium à dopage p, qui se trouve à un potentiel entraînant l'interruption de la gravure étant insolé avec de la lumière de longueur d'onde inférieure à 1,1 µm, le potentiel d'interruption de gravure étant ainsi décalé dans la direction anodique de telle sorte que le processus de gravure soit déclenché, la tension appliquée étant choisie telle qu'elle se situe entre les potentiels d'interruption de gravure avec et sans insolation.

2. Procédé électrochimique pour la gravure anisotrope de silicium à dopage n intégral ou au moins partiel, à l'aide d'une solution basique avec un pH supérieur à 12, une réduction d'ordre deux à trois de la vitesse de gravure étant obtenue par l'application aux zones du silicium à dopage n d'une tension positive par rapport au potentiel de repos et du silicium à dopage n, qui, à l'état non insolé, se trouve à une tension positive, juste en-dessous du potentiel d'interruption dans l'obscurité, étant insolé avec de la lumière de longueur d'onde inférieure à 1,1 µm, le potentiel d'interruption de gravure étant ainsi décalé dans la direction cathodique de telle sorte que le processus de gravure en cours soit interrompu.

3. Procédé selon la revendication 1 ou 2, caractérisé par le fait que l'on insole le silicium de manière sélective à l'aide d'un rayon laser focalisé.

4. Procédé selon la revendication 1 ou 2, caractérisé par le fait que l'on insole le silicium de manière sélective à l'aide d'un masque correspondant à la forme souhaitée de la structure.

5. Procédé selon une ou plusieurs des revendications 1 à 4, caractérisé par le fait que l'on utilise la profondeur de pénétration de la lumière dans le silicium pour ajuster directement l'épaisseur de membranes, de ponts ou de cordons.

6. Procédé selon une ou plusieurs des revendications 1 à 5, caractérisé par le fait que l'on utilise comme solution basique du KOH, NaOH, NH₄OH ou CsOH.
